# EUROPEAN PATENT APPLICATION

(11) **EP 4 303 597 A1**
(43) Date of publication of application: **10.01.2024**
(21) Application number: 22762659.5
(22) Date of filing: 28.02.2022
(51) Int. Cl.: G01R 31/12

(54) **INSULATED, SHIELDED PARTIAL DISCHARGE SENSOR DEVICE OF THE HIGH-FREQUENCY CURRENT TRANSFORMER (HFCT) TYPE, WITH HIGH GAIN AND LOW DISTORTION, AND WITH SELF-CHECK SYSTEM FOR HIGH-VOLTAGE EQUIPMENT AND INSTALLATIONS**

(30) Priority: 03.03.2021 ES 202130183
(71) Applicant: Universidad Politécnica De Madrid, 28040 Madrid (ES); Viesgo Distribución Eléctrica S.L., 39011 Santander (ES)
(72) Inventor: GARNACHO VECINO, Fernando, 28040 Madrid (ES); KHAMLICHI EL KHAMLICHI, Abderrahim, 28040 Madrid (ES)
(74) Representative: Elzaburu S.L.P.
(86) International application number: PCT/ES2022/070106
(87) International publication number: WO 2022/184953

(57) **Abstract**

The present invention relates to a high gain, low distortion and high noise immunity high frequency current transformer, HFCT, partial discharge sensor device that allows obtaining a high measurement accuracy, with a self-check system intended for fixed monitoring of high voltage equipment and installations, comprising a ferrite core; a first measurement coil wound to the ferrite core; and a first coaxial cable welded to the first measurement coil; wherein the sensor device further comprises: a second auxiliary check coil wound to the ferrite core; an electrical resistance in series with the auxiliary check coil; a second coaxial cable welded to the electrical resistance; and an outer coating of resin.

## Description

### OBJECT OF THE INVENTION

The present invention relates to the technical field of protection systems that use the measurement of partial discharges and more specifically to a partial discharge measurement sensor of the "high frequency current transformer" (HFCT) type to be connected to a digital input impedance measurement instrument of 50Ω, with a gain of 9 mV/mA, bandwidth of 0.5 MHz to 40 MHz, flat response (<±10%) between 1 MHz and 30 MHz, and better immunity of -40 dB against external interference of frequencies up to 30 MHz of electric field value of up to 60 V/m and with self-check system to check its correct status.

The sensor, object of the present invention, has application in the earthing of high voltage equipment and installations, such as the braids of the screens of the power cable systems connected to the ground through which partial discharge pulses are drained.

### BACKGROUND OF THE INVENTION

Currently, high-frequency current transformers are commonly used sensors in the measurement of partial discharges.

The state of the art comprises some sensors for the measurement of partial discharges, but their performance in high frequency ranges (between 1 MHz and 30 MHz) is not fully satisfactory on all occasions. In many cases, the gain expressed in mV/mA (or "transfer impedance" in the literature), which is the output voltage of the sensor with respect to the input current when it is loaded with an impedance of 50Ω, is not very flat in the high frequency range, which implies greater distortion of the signal to be measured and, therefore, greater insecurity of the device.

The sensors present in the market, when they present a high gain (>8 mV/mA) in the frequency range of interest from 1 MHz to 30 MHz, are not able of keeping their gain constant in the high frequency band from 1 MHz to 30 MHz, so they significantly distort the shape of the partial discharge pulse to be measured, negatively affecting the accuracy of the measurement. On the other hand, sensors that keep their gain characteristic constant in the aforementioned frequency range have a low gain (<5 mV/mA).

Another general problem of state-of-the-art sensors used for permanent monitoring of high voltage installations is that they have a single coil wound on the ferrite toroidal core to measure the partial discharge pulses. However, due to stresses in high voltage networks, such as short circuits, surges due to manoeuvres or atmospheric discharges (lightning), the ferrites of these sensors may suffer premature degradation and consequently lose their gain. This loss of gain would be unnoticed by the user of the sensor, and may be ineffective for the detection of partial discharges, so the only option to detect this fault would be to carry out a review of its characteristics, which would require it to be removed to test it in the laboratory or, where appropriate, test it in situ. In any case, this involves the problem of accessing the sensor and disconnecting the network.

High-frequency current transformer (HFCT) type sensors are used for the monitoring of partial discharges in high voltage installations under high electric field service conditions, to the order of tens of volts per meter. Therefore, it is very convenient to have a metal shield to ensure that the measurement signal is immune to interference electric fields characteristic of high voltage electrical installations. However, many of the sensors on the market do not even have shielding, which directly affects the interference voltage induced in the measurement coil to an order of magnitude higher than that captured by other sensors that do have metal shielding.

Among the existing shielded sensors in the state of the art, there are shields by means of a copper or aluminium metallic envelope, painted or coated with an insulating layer. These shields may be effective in terms of immunity, but they are deficient from an electrical insulation point of view, since an abrasion or defect in the insulating coating layer may cause dangerous voltages to be derived on its shield and consequently on the measuring cable, endangering the integrity of the measuring instrument and even the operator who handles it.

Therefore, an alternative to existing sensors is lacking in the state of the art, capable of offering at the same time a high gain, flat response in high frequency, immunity to interference, electrical insulation and guarantees of correct operation without having to disassemble it for repairs, in a realistic and low cost format.

### DESCRIPTION OF THE INVENTION

in order to achieve the objectives and avoid the aforementioned drawbacks, the present invention describes, in a first embodiment, a partial discharge sensor device of the high-frequency current transformer, HFCT, type for high voltage equipment and installations, comprising:
- a ferrite core;
- a first measuring coil wound to the ferrite core; and
- a first coaxial cable welded to the first measuring coil;
wherein the sensor device further comprises:
- a second auxiliary check coil wound to the ferrite core;
- an electrical resistance in series with the auxiliary check coil;
- a second coaxial cable welded to the electrical resistance;
- a copper shield; and
- an outer resin coating.

Specifically, in one embodiment of the invention, the first measuring coil comprises five flat loops and an additional return loop which is also flat. Thus, advantageously, the gain reaches a value of 9 mV/mA and is constant (<±10%) in the range between 0.5 MHz and 30 MHz.

The additional return loop serves to improve the frequency response of the sensor and is arranged on an outer cylindrical surface of the ferrite core, insulated from the five flat loops that make up the coil. Specifically, in a particular embodiment, a final terminus of the additional return loop is arranged following a U-shaped geometry with appropriate dimensions to achieve a matching impedance of 50Ω, equal to that of the measurement cable. As for the five flat loops, according to one embodiment of the invention, they have dimensions of 5 mm wide and 125 µm thick.

According to one of the embodiments of the invention, the first measurement coaxial cable has a characteristic impedance 50 Ω and is soldered to the first measurement coil as follows: the shield of the coaxial cable soldered to the final terminus of the measurement coil corresponding to the return turn and the active conductor of the coaxial cable soldered to the initial terminus of the measurement coil, which is adapted in impedance to the average cable, thanks to the U-shaped geometry of the final terminus of the return loop. Additionally, in one of the particular embodiments, it is contemplated to provide an insulating, adhesive, flexible and transparent sheet of polyamide film covering the welds between the coaxial cable and the first measuring coil.

The second auxiliary check coil, according to one of the embodiments of the invention, comprises two loops. Additionally, it is contemplated to provide an electrical resistance connected in series with the second auxiliary check coil 300Ω.

The ferrite core of the sensor device according to one embodiment of the invention is a high permeability MnZn ferrite toroidal core. Specifically, in one of the embodiments, measurements are contemplated for the ferrite core with an inner diameter of 54.3 mm, an outer diameter of 87.0 mm and a thickness of 13.5 mm. Additionally, it is contemplated that the ferrite core be split into two equal halves with two air gaps of 125 µm each.

According to a particular embodiment, copper banding is provided which is at least 35 µm thick and U-shaped, which shields the assembly of the ferrite core, first measuring coil and second auxiliary coil. The shielding covers the outer cylindrical surface of the ferrite toroidal core with the two coils and their two circular crowns, which constitute the lower and upper base of the core, leaving only the inner cylindrical part of the toroid, through which the earth cable(s) passes, unshielded. This U-shaped shielding allows the current pulse of the partial discharge to induce a magnetic flux through the ferrite core, but at the same time prevents external interferences from inducing appreciable flux of interference in the core.

The shielded assembly is embedded with an outer coating of resin to form the sensor device of the present invention. It is contemplated that it comprises an epoxy resin layer at least 3 mm thick. In addition, the resin layer incorporates a mark in the form of an arrow pointing towards the ground, which guides the correct installation of the device, thanks to a mould designed for it. If this mark is not accommodated in the resin, it would have to be incorporated in a supplementary way, for example, by means of a sticker, with the drawbacks of having to withstand the weather of an outdoor installation. This arrow mark in the direction of the earth of the installation is important to identify the polarity of the pulse and with it identify if the defect comes from inside or outside the installation or equipment.

The present invention therefore offers an advantageous alternative to the state-of-the-art solutions of the high-frequency current transformer types using ferrite as a magnetic core, since the specific coiling materials and techniques achieve a low-cost sensor and high gain and bandwidth performance from 0.5 MHz to 50 MHz with flat response (<±10%) in the range from 1 MHz to 30 MHz, which achieve high measurement accuracy, thanks to the selection of a MnZn ferrite and a measurement coil with flat loops and a return coil which is also flat, mounted on the outer cylindrical surface of the ferrite, with a resin-embedded copper shielding that simultaneously gives it excellent immunity and high external dielectric strength (> 10 kV) at a low cost.

The characteristics listed below make the sensor of the present invention especially advantageous over those existing in the state of the art.
1) High gain⁽¹⁾ (> 8 mV/mA) and constant (<±10%) in the range of 1 MHz to 30 MHz. The sensor device of the present invention has a characteristic curve of gain as a function of frequency that presents a high gain of 9 mV/mA with flat response (< ±10%) in the frequency range of interest, between 1 MHz and 30 MHz, thanks to the five loops with return loop, all of them flat and wound to the MnZn ferrite.
2) Self-checking by means of an auxiliary signal injection coil. The present invention has an auxiliary coil so that a known signal can be injected remotely to check, even remotely, the signal measured by the sensor and in this way check if it is within the operating tolerances or otherwise shows a fault, without having to access the sensor, other than for replacement in case of a fault being detected. Although the existence of this auxiliary coil could mitigate the gain of the sensor, a resistance has been arranged in series with the self-check coil to maintain a high gain of 9 mV/mA, with a flat response (<±10%) in the frequency range of 1 MHz to 30 MHz. The gain loss when incorporating the self-check auxiliary winding is less than 5% for the frequency range up to 70 MHz, which justifies the correct design of the sensor.
3) High interference immunity, better than -40 dB, for frequencies up to 30 MHz. The sensor device of the present invention has an internal copper shield, which protects the measuring and self-checking coils, as well as the ferrite core and which is embedded in resin. This shielding is effective for frequencies up to 30 MHz, with a shielding characteristic curve comparable with those of other sensors on the market with copper or aluminium outer shell shielding. The advantage of the internal shielding made by means of copper adhesive tape of less than 0.2 mm compared to the external shielding of aluminium or copper sheet of 1 mm, is its lower cost, greater compaction of the sensor and better possibility of external electrical insulation when embedded in resin.
4) High electrical insulation characteristics (>10 kV; 50 Hz). The partial discharge sensor device of the present invention uses an internal copper shield, embedded in an epoxy resin thickness of at least 3 mm thick, to guarantee an electrical insulation greater than 10 kV at 50 Hz, a value greater than any voltages that are considered to appear in the earthed masses of high-voltage equipment and installations.
5) High corrosion performance. The partial discharge sensor device of the present invention has embedded in its resin all the elements that make up the magnetic and electrical circuit, with the exception of the cables that come out of the sensor. This compact design is integrated into a resin block that makes the whole a robust sensor against the effects of corrosion, as there are no external metal parts exposed to corrosive atmospheric agents that could appear in the vicinity of the installation where it is installed. The only metal elements of the sensor correspond to the BNC connectors at the ends of both coaxial cables that connect to the measuring instrument, where the environmental conditions must be in accordance with an correct instrumentation environment.

### BRIEF DESCRIPTION OF THE FIGURES

To complement the description of the invention and for the purpose of aiding the better understanding of its characteristics, in accordance with a preferred example of embodiment thereof, a set of drawings is attached wherein, by way of illustration and not limitation, the following figures have been represented:
- **Figure 1** depicts a perspective view of an embodiment of the sensor.
- **Figure 2** conceptually depicts the magnetic circuit of the sensor.
- **Figure 3** conceptually depicts the "U" shielding of the coils.
- **Figure 4** shows a constructive solution of the present invention, with detail in the core and the winding of the measuring coil.
- **Figure 5** shows in detail the U-shaped arrangement of the terminus of the return coil, shielding the initial terminus of the measuring coil.
- **Figure 6** shows in detail the connection of the coaxial cable with the measuring coil.
- **Figure 7** shows the insulating layer placed over the cable welds and the measuring coil.
- **Figure 8** represents a view of the resin-embedded sensor and the measurement coaxial cables.

### DESCRIPTION OF A PREFERRED EMBODIMENT OF THE INVENTION

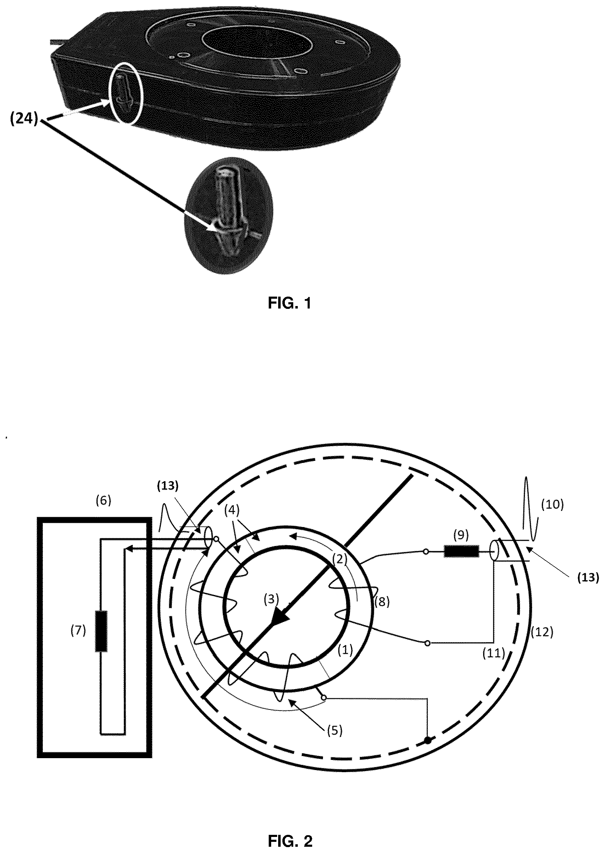

The present invention discloses a partial discharge sensor device of the high-frequency current transformer, HFCT, type for high voltage equipment and installations, such as the one shown in **figure 1****.**

**Figure 2** conceptually represents the magnetic circuit of the device, composed of a ferrite core **(1)** of high permeability, in which the magnetic field **(2)** produced by the transient current pulses i(t) to be measured **(3)** of the partial discharges is induced. The core is divided into two equal halves **(4)** so that the two air gaps prevent the saturation of the ferrite before alternating currents of 50 Hz that circulate through the cable shield or the earth of the equipment in which the sensor is arranged. A coil of five loops plus one return loop **(5)** is wound on the ferrite core so that a current proportional to the partial discharge transient current i(t) to be measured flows. The signal picked up by the coil must be measured through a measuring instrument **(6)** with input impedance of 50 Ω **(7)**. A second two-turn coil **(8)** in series with a damping resistor **(9)** is used to inject a self-check pulse **(10)** when required. A coaxial cable **(13)** of 50 Ω characteristic impedance is connected to each of the coils, through the resistor (9) in the case of the self-check coil. The coils, resistance and connections with the coaxial cables are shielded by a copper tape **(11)** that is embedded in resin **(12).**

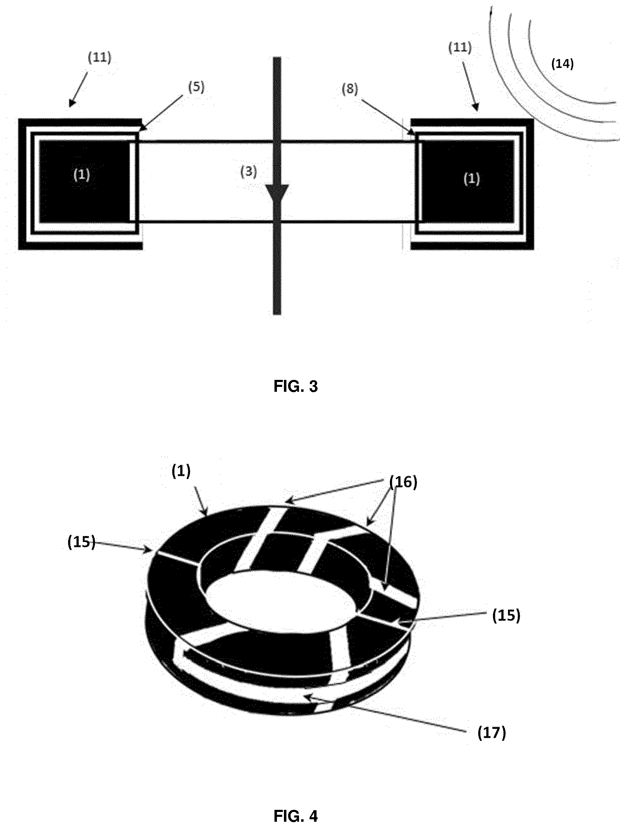

**Figure 3** shows how the ferrite core **(1),** the measuring coil **(5)** and the self-check coil **(8)** are shielded by a U-shaped copper tape **(11),** to mitigate external interference **(14),** while being able to capture the magnetic field created by the current pulse i(t) of the partial discharge **(3).** Insulation tapes are used to electrically insulate the ferrite **(1)** from the coils **(5)** and **(8),** the coils from each other and these from the copper shielding **(11).** The coaxial cable shield corresponding to the measuring coil **(5)** and the internal copper shield are electrically connected at a single point to form the sensor earth.

**Figure 4** shows in detail the constructive solution of the present invention in this preferred embodiment. It consists of a ferrite toroidal core MₙZₙ **(1)** of initial relative permeability of 6,000, inner diameter 54.3 mm and outer diameter 87.0 mm and thickness 13.5 mm. The core is divided into two equal halves with two air gaps of 125 µm each, as shown by the marks **(15)** in Figure 4. The purpose of the air gaps is to avoid saturation of the core for the 50 Hz currents foreseen in operation by the cables or earths where the sensor is connected. The ferrite core is covered with an adhesive, flexible and transparent insulating sheet of polyamide film, or alternatively it can be coated with insulating varnish of low relative permittivity (<2.5), on which are wound five flat coils **(16)** of 125 µm thickness and 5 mm width and an additional return coil **(17)** fixed on the outer cylindrical surface of the ferrite of the same dimensions of width and thickness as the coils wound on the toroidal core.

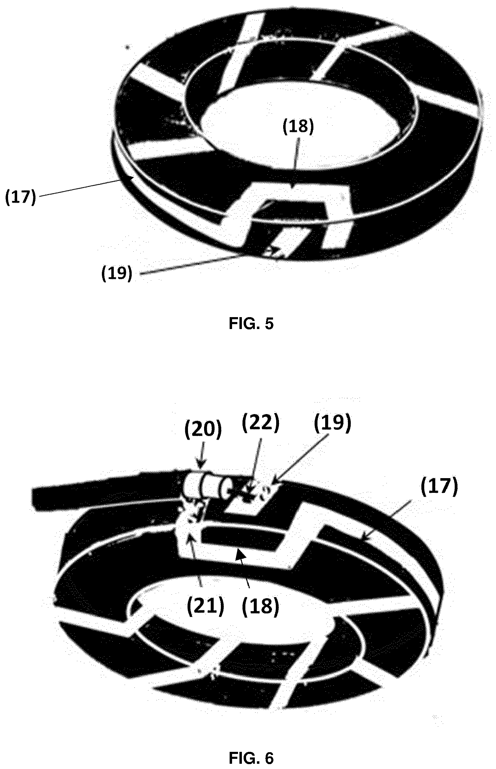

**Figure 5** shows in detail how the final terminus of the return coil **(17)** is shaped with a U-shaped geometry **(18),** with appropriate dimensions to achieve a matching impedance of 50 Ω, in order to shield and match the initial terminus **(19)** of the measurement coil with the characteristic impedance of the measurement cable.

A coaxial measurement cable, of characteristic impedance 50Ω, soldered with tin to the measurement coil is shown in detail in **Figure 6****.** Specifically, the shield **(20)** of the coaxial cable is welded to the terminus **(21)** of the return coil **(17)** and the active conductor of the coaxial cable **(22)** is welded to the initial terminus **(19)** of the measuring coil, which is shielded in the U-shaped geometry **(18)** of the final terminus of the return coil **(17).**

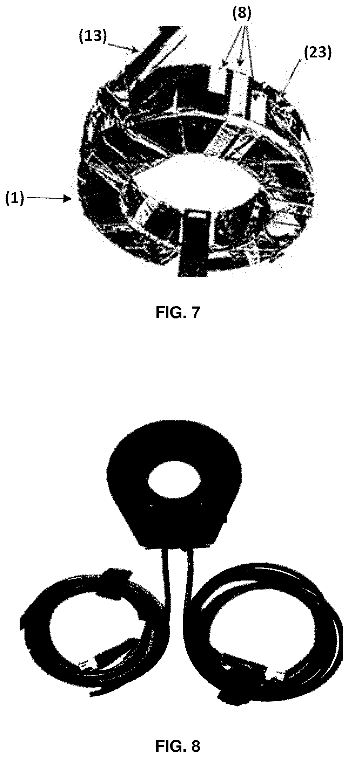

As shown in **Figure 7****,** the solder connection of the coaxial cable and the measuring coil is covered by an adhesive, flexible and transparent insulating sheet **(23)** of polyamide film, to electrically separate them from the copper shield that is installed on top. Before arranging the copper shield, the second two-turn coil **(8)** is arranged on the insulating layer **(23)** covering the toroidal ferrite core **(1)** and the welds of the measuring coaxial cable **(13).** The self-check coil is also insulated with an adhesive, flexible and transparent insulation sheet. Instead of having adhesive, flexible and transparent insulating sheets, insulating varnish of equivalent insulating technical characteristics can be provided. This auxiliary coil **(8)** allows the self-check of the sensor gain. The self-check coil must not overlap with any loop of the measuring coil, so when winding the measuring coil, an angular sector of, preferably, about 3 cm of external arc must be left free, without covering the ferrite toroidal core.

The auxiliary coil has connected in series a damping resistance, in this preferred embodiment of 300Ω, so as not to appreciably affect (<5%) the gain of the measuring coil. The welding connections of the resistance with the self-checking coil and with the active coaxial cable, as well as that of the shield of the latter with the other end of the coil are insulated by a polyamide film.

The ferrite core assembly **(1)** and the two coils (the measuring one **(5)** and the auxiliary one **(8)** for self-checking), are shielded **(11)** by means of copper banding of at least 35 µm thick, in a U shape to cover the outer cylindrical surface of the toroid and the two circular crowns, which constitute the lower and upper bases of the toroid. The shielding leaves the inner cylindrical part of the toroid uncovered, as shown in **Figure 3****,** so that the current pulse of the partial discharge **(3)** that circulates through the earth conductor can be coupled to the ferrite toroid, while the external interferences **(14)** are mitigated by the shielding. The measurement cable shield is internally connected to the copper shield.

The ferrite assembly, the two shielded coils (the measuring and the checking one), the connections of the two coaxial cables welded to both coils, the series resistance and the copper shielding are embedded in resin, typically black, to achieve a coating of at least 3 mm thick with an external shape as shown in **Figure 1****.** In the resin mould built for this purpose, an arrow-shaped mark **(24)** is formed on one side of the sensor, so that from the outside of the resulting resin block its correct position can be identified, arrow pointing towards the ground when installed. In this way it is possible to identify the polarity of the measurement pulse.

In one of the preferred embodiments, as shown in **Figure 8****,** the sensor device has outer dimensions of 110 mm wide and 125 mm high, with a thickness of 25 mm. It can be supplied with a coaxial cable with a maximum length of 15 m, although it is advisable to keep the length as short as possible so as not to lose gain.

The present invention should not be limited to the embodiment described herein. Other closed type sensor configurations as described or open type in two halves that can be coupled together, in which each half includes half a ferrite toroid and one of the coils, can be made by those skilled in the art in view of the present disclosure. Accordingly, the scope of the invention is defined by the following claims.

## Claims

1. A high frequency current transformer, HFCT, type partial discharge sensor device for high voltage equipment and installations, comprising:
- a toroidal ferrite core (1);
- a first measuring coil (5) wound to the ferrite core (1); and
- a first coaxial cable (13) welded to the first measuring coil;
wherein the sensor device is **characterized by** further comprising:
- a second auxiliary check coil (8) wound to the ferrite core (1);
- an electrical resistance (9) in series with the auxiliary check coil (8);
- a second coaxial cable (13) welded to the electrical resistance; and
- a U-shaped copper shield (11), which shields the assembly formed by the ferrite toroidal core (1), the first measuring coil (5) and the second auxiliary checking coil (8); and
- an outer resin coating (12).

2. Device according to claim 1 wherein the first measuring coil comprises five flat loops and an additional return loop.

3. Device according to claim 2 wherein the additional return loop is fixed on an outer cylindrical surface of the ferrite core.

4. Device according to claim 3 wherein a final terminus of the additional return loop has a U-shaped geometry with dimensions corresponding to a wave impedance equal to that of a 50 Ω measurement cable.

5. Device according to any of claims 2-4, wherein the five flat loops have dimensions of 125 µm thick and 5 mm wide

6. Device according to any one of the preceding claims, wherein the first coaxial measurement cable has a characteristic impedance 50 Ω and is welded to the first measurement coil as follows: a shield of the coaxial cable welded to the terminus of the additional return loop and the active conductor of the coaxial cable to the initial terminus of the measurement coil, connection that is shielded in the U-shaped geometry of the final terminus of the return loop.

7. Device according to claim 6 further comprising an element to be selected from an insulating, adhesive, flexible and transparent sheet of polyamide film and an insulating varnish, covering the first measuring coil, the second self-check coil and the welds of both coaxial cables.

8. A device according to any one of the preceding claims, wherein the second auxiliary check coil comprises two loops.

9. Device according to any one of the preceding claims, wherein the electrical resistance in series with the second auxiliary check coil is a resistance of 300 Ω.

10. Device according to any of the preceding claims, wherein the ferrite toroidal core is a high permeability MnZn ferrite toroidal core.

11. Device according to claim 7 wherein the copper shielding comprises a copper tape with at least 35 µm thickness and U-shaped, which shields in addition to the ferrite core and the measuring and self-checking coils, the welds of both coaxial cables and the insulating sheet or varnish, covering the outer cylindrical surface of the toroidal core and its two circular crowns, which constitute a lower base and an upper base of the assembly, leaving only the inner cylindrical part of the toroidal core without shielding.

12. Device according to any of the preceding claims, wherein the toroidal ferrite core has an inner diameter of 54.3 mm, an outer diameter of 87.0 mm and a thickness of 13.5 mm.

13. Device according to any of the preceding claims, wherein the toroidal ferrite core is split into two equal halves with two air gaps of 125 µm each.

14. Device according to any of the preceding claims, wherein the outer resin coating comprises an epoxy resin layer of at least 3 mm thickness.

15. Device according to claim 14 wherein the resin layer comprises an arrow-shaped mark pointing towards the earth of the installation, which guides the correct installation of the device.
